# EUROPEAN PATENT SPECIFICATION

(11) **EP 3 808 879 B1**
(45) Date of publication and mention of the grant of the patent: **01.03.2023**
(21) Application number: 19820517.1
(22) Date of filing: 13.05.2019
(51) Int. Cl.: H01L 21/66, H01L 21/263

(54) **METHOD FOR CONTROLLING DEFECT DENSITY IN SILICON SINGLE CRYSTAL SUBSTRATE**
VERFAHREN ZUR KONTROLLE DER DEFEKTDICHTE BEI EINEM SILIZIUM-EINKRISTALLSUBSTRAT
PROCÉDÉ DE RÉGULATION DE DENSITÉ DE DÉFAUTS DANS UN SUBSTRAT MONOCRISTALLIN DE SILICIUM

(30) Priority: 12.06.2018 JP 2018112062
(43) Date of publication of application: 21.04.2021
(73) Proprietor: Shin-Etsu Handotai Co., Ltd., Tokyo 100-0004 (JP)
(72) Inventor: TAKENO Hiroshi, Annaka-shi, Gunma 379-0196 (JP)
(74) Representative: Wibbelmann, Jobst
(86) International application number: PCT/JP2019/019004
(87) International publication number: WO 2019/239762

(56) References cited:
- JP-A- 2001 068 477
- JP-A- 2001 240 490
- JP-A- 2004 304 095
- JP-A- 2015 023 062
- JP-A- 2015 156 420
- JP-A- 2015 198 166
- SGOUROU, E. N. et al.: "Infrared study of defects in nitrogen- doped electron irradiated silicon", J. Mater. Sci, Mater. Electron., vol. 27, no. 2, 4 November 2015 (2015-11-04), pages 2054-2061, XP035915176, ISSN: 0957-4522, DOI: 10.1007/s10854-015-3991-2

## Description

### TECHNICAL FIELD

The present invention relates to a method for controlling a defect density in a silicon single crystal substrate.

### BACKGROUND ART

In semiconductor-device manufacturing processes using silicon single crystal substrates, particle beam irradiation and heat treatment are frequently performed. For example, in a step of forming a source or drain of a transistor, ions of a dopant are implanted at high concentration, and then a heat treatment is performed to activate the dopant and to recover damage caused by the ion implantation. In addition, in a step of controlling the recombination lifetime of excess carriers in a power device, defects which become recombination centers of carriers are introduced on purpose by irradiation with particle beams such as electron beams or protons, and the recombination lifetime is adjusted by the subsequent heat treatment.

When a silicon single crystal substrate is irradiated with a particle beam having high energy, a silicon atom at a lattice position is flicked out, and interstitial silicon (I) and vacancy (V) which is an empty shell thereof are produced. The excessively produced I or V is unstable when it is alone, so that they recombine (V+I_{→}0), clustering of I's or V's occurs, or they react with a light element impurity contained in the silicon single crystal substrate to form a composite. Additionally, the cluster of I's or V's or the composite of I or V with a light element impurity forms a deep level in a bandgap of silicon, and functions as a recombination center and generation center of carriers. In a case where these recombination center and generation center degrade device characteristics, it is desirable to reduce the density of light element composite as much as possible.

Meanwhile, for power devices such as IGBT (Insulated Gate Bipolar Transistor) and diode, there has been conventionally adopted a technology utilizing particle beam irradiation and heat treatment to intentionally introduce defect which becomes a recombination center of carriers into a silicon single crystal substrate, and to control and shorten the recombination lifetime of the carriers, thereby increasing the switching speed and consequently reducing switching loss (Patent Documents 1 to 4). In this case, multiple types of defects serving as recombination centers are introduced near room temperature by particle beam irradiation, and thermally unstable defect types are also present among them. Hence, a heat treatment is performed after the particle beam irradiation to annihilate the thermally unstable defects and adjust the defect density, so that a desired value of the recombination lifetime is obtained.

However, even when the same conditions for the particle beam irradiation or the heat treatment after the particle beam irradiation are employed, there still remains a problem that device characteristics vary (Non Patent Documents 1 to 4). As a cause of the variation in device characteristics, some substance contained in silicon substrates themselves is suspected as a factor. Particularly, an influence from carbon or oxygen as impurities is concerned.

Non Patent Document 1 has pointed out a problem that switching loss sometimes occurs depending on wafers even when the same recombination lifetime control is carried out. Non Patent Document 1 has indicated that among primary defects (CsI, CiCs, or CiOi) produced by electron beam irradiation, only CiOi has the wafer dependence in its activation energy, and the activation energy tends to escalate when the oxygen concentration is high, consequently suggesting that oxygen impurities are a factor of the wafer dependence (where Cs: substitutional carbon, Ci: interstitial carbon, Oi: interstitial oxygen, I: interstitial silicon). Moreover, Non Patent Documents 2 and 3 have shown that when a heat treatment is performed at 350°C±10°C after electron beam irradiation, there is a correlation between V_{CE (sat)}, which is ON voltage of IGBT, and CiOi-derived C-line emission intensity measured by a photoluminescence method. Further, Non Patent Document 4 states that, to improve the recovery characteristics of FWD (Free Wheeling Diode), when crystal defects are locally introduced at a level equivalent to or more than donor concentration as in the case of He irradiation, it is important to control the density of CiOi that functions as hole trap, and consequently it is important to control the carbon concentration. In such cases, control is required to reduce the variation in the density of light element composite as much as possible.

### CITATION LIST

### PATENT LITERATURE

Patent Document 1: Japanese Unexamined Patent Application Publication No. H11-135509
Patent Document 2: Japanese Unexamined Patent Application Publication No. 2000-200792
Patent Document 3: International Publication No. WO2013/100155
Patent Document 4: International Publication No. WO2007/055352
Patent Document 5: Japanese Unexamined Patent Application Publication No. 2015-198166

### NON PATENT LITERATURE

Non Patent Document 1: Kiyoi et al., The 61st Japan Society of Applied Physics Spring Meeting, Meeting Proceedings, 19p-F9-14.
Non Patent Document 2: Minato et al., The 4th Workshop on Power Device Silicon and Related Semiconductor Materials, p. 77.
Non Patent Document 3: K. Takano et al., Proceeding of the 27th International Symposium on Power Semiconductor Devices & IC's, 2015, p. 129.
Non Patent Document 4: Sugiyama et al., The 4th Workshop on Power Device Silicon and Related Semiconductor Materials, p. 71.

### SUMMARY OF INVENTION

### TECHNICAL PROBLEM

As described above, to enhance device characteristics, more strict control is required over the density of light element composite formed by particle beam irradiation and heat treatment.

Generally, it is believed that if the same conditions of particle beam irradiation and heat treatment after the particle beam irradiation are employed, the density of light element composite formed by the particle beam irradiation and heat treatment can be controlled by controlling the concentration of carbon and/or oxygen which are constituent elements of the light element composite. However, this is not always true in reality. There has been a problem that even when the same conditions regarding the carbon concentration and the oxygen concentration are employed, this does not always result in light element composites of the same density.

The present invention has been made in view of the above-described problems. An object of the present invention is to provide a method for controlling a defect density in a silicon single crystal substrate in such a manner to enable highly precise control of the defect density and reduction of a variation in defect density resulting from silicon single crystal substrates in a device-manufacturing process which controls defect density by particle beam irradiation and heat treatment.

### SOLUTION TO PROBLEM

To achieve the object, the present invention provides a method for controlling a defect density in a silicon single crystal substrate by performing:
a preparation step of preparing a silicon single crystal substrate whose defect density is to be controlled;
a particle beam irradiation step of irradiating the prepared silicon single crystal substrate with a particle beam; and
a heat treatment step of performing a heat treatment on the silicon single crystal substrate after the particle beam irradiation step,
the method comprising:
   a measurement step comprising irradiating a plurality of test silicon single crystal substrates having different nitrogen concentrations with the particle beam in advance before performing the preparation step, then carrying out a heat treatment, and measuring densities of defects produced in the plurality of test silicon single crystal substrates; and
   a correlation acquisition step of acquiring a correlation between the measured defect densities and the nitrogen concentrations,
   wherein a nitrogen concentration of the silicon single crystal substrate prepared in the preparation step is adjusted based on the acquired correlation in such a manner that the defect density in the silicon single crystal substrate reaches a target value after the heat treatment step.

In this manner, when the defect density of a silicon single crystal substrate is controlled by adjusting the nitrogen concentration thereof based on the correlation, which is obtained in advance from the test silicon single crystal substrates, between the defect densities in the silicon single crystal substrates after the heat treatment and the nitrogen concentrations, this makes it possible to reduce a variation in defect density resulting from silicon single crystal substrates.

Moreover, in this event, the defect to be controlled in relation to the defect density is preferably a composite containing carbon or carbon and oxygen.

Silicon single crystal substrates have carbon and oxygen as impurities mixed during the crystal growth. Thus, controlling the defect density of such a silicon single crystal substrate by adjusting the nitrogen concentration in the silicon single crystal substrate on the basis of the correlation between the concentration of a composite containing carbon or carbon and oxygen after the heat treatment and the nitrogen concentrations enables reduction of a variation in defect density resulting from silicon single crystal substrates.

More preferably, the defect density is measured in the measurement step by a method of a cathode luminescence method or a photoluminescence method.

The cathode luminescence method and photoluminescence method enable observation of a G-line or a C-line which are emission lines derived from a composite containing carbon or carbon and oxygen. Hence, the cathode luminescence method or photoluminescence method can be suitably employed as the method for measuring the concentration of a composite containing carbon or carbon and oxygen.

Further preferably, the prepared silicon single crystal substrate is manufactured from a nitrogen-added silicon single crystal grown by a floating zone method (FZ method).

In the case of an FZ silicon single crystal substrate, nitrogen is often added during crystal growth in order to reduce crystal defect introduced during the crystal growth and enhance the wafer strength. The concentration of nitrogen to be introduced in the grown single crystal can be controlled by adjusting the atmospheric gas during the crystal growth. Controlling the defect density of such an FZ silicon single crystal substrate by adjusting the nitrogen concentration in the silicon single crystal substrate on the basis of the correlation between the defect densities in the silicon single crystal substrates after the heat treatment and the nitrogen concentrations enables further reduction of a variation in defect density resulting from silicon single crystal substrates.

Further preferably, the nitrogen concentration of the silicon single crystal substrate prepared in the preparation step is adjusted to vary from a target nitrogen concentration value at most by 10%.

With the nitrogen concentration variation within 10% as described above, the variation in defect density resulting from silicon single crystal substrates can be further reduced.

### ADVANTAGEOUS EFFECTS OF INVENTION

The inventive method for controlling a defect density in a silicon single crystal substrate makes it possible to highly precisely control the defect density by adjusting the nitrogen concentration of the silicon single crystal substrate, so that a variation in defect density resulting from silicon single crystal substrates can be reduced. Moreover, when the defect density of a nitrogen-added FZ silicon single crystal substrate is to be controlled also, the present invention is capable of highly precisely controlling the defect density, and thus particularly suitable when a nitrogen-added FZ silicon single crystal substrate is used for a power device.

### BRIEF DESCRIPTION OF DRAWINGS

FIG. 1 is a flowchart for illustrating a method for controlling a defect density in a silicon single crystal substrate according to the present invention.
FIG. 2 shows graphs for illustrating examples of an emission spectrum measured by a cathode luminescence method in Experimental Example with an oxygen concentration of approximately 0.2 ppma.
FIG. 3 shows graphs for illustrating examples of an emission spectrum measured by the cathode luminescence method in Experimental Example with an oxygen concentration of less than 0.1 ppma.
FIG. 4 is a graph for illustrating a relation between G-line intensity and nitrogen concentration with an oxygen concentration of less than 0.1 ppma.
FIG. 5 is a graph for illustrating a relation between C-line intensity and nitrogen concentration with an oxygen concentration of less than 0.1 ppma.
FIG. 6 is a graph for illustrating a relation between G-line intensity and nitrogen concentration with an oxygen concentration of 0.1 to 0.3 ppma.
FIG. 7 is a graph for illustrating a relation between C-line intensity and nitrogen concentration with an oxygen concentration of 0.1 to 0.3 ppma.

### DESCRIPTION OF EMBODIMENTS

Hereinafter, embodiments of the present invention will be described, but the present invention is not limited thereto.

As noted above, the conventional techniques control the defect density in a silicon single crystal substrate by adjusting the particle beam irradiation condition and the heat treatment condition after the particle beam irradiation. In this case, there is a problem that the defect density varies due to some factor resulting from silicon single crystal substrates.

The present inventor has earnestly studied and found that after silicon single crystal substrates are subjected to particle beam irradiation and heat treatment, the resulting defect densities vary even when the carbon concentration and the oxygen concentration are approximately the same which have been conventionally believed to be variation factors; this defect density variation strongly depends on the nitrogen concentration of the silicon single crystal substrates. These findings have led to the completion of the present invention.

Specifically, the present invention is a method for controlling a defect density in a silicon single crystal substrate by performing:
a preparation step of preparing a silicon single crystal substrate whose defect density is to be controlled;
a particle beam irradiation step of irradiating the prepared silicon single crystal substrate with a particle beam; and
a heat treatment step of performing a heat treatment on the silicon single crystal substrate after the particle beam irradiation step,
the method comprising:
   a measurement step comprising irradiating a plurality of test silicon single crystal substrates having different nitrogen concentrations with the particle beam in advance before performing the preparation step, then carrying out a heat treatment, and measuring densities of defects produced in the plurality of test silicon single crystal substrates; and
   a correlation acquisition step of acquiring a correlation between the measured defect densities and the nitrogen concentrations,
   wherein a nitrogen concentration of the silicon single crystal substrate prepared in the preparation step is adjusted based on the acquired correlation in such a manner that the defect density in the silicon single crystal substrate reaches a target value after the heat treatment step.

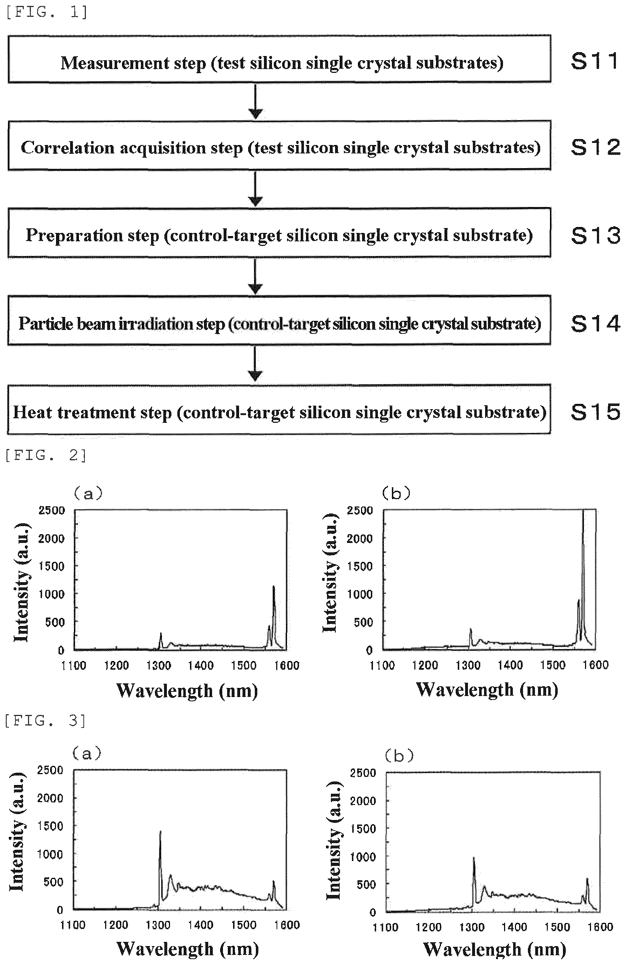

Hereinafter, the inventive method for controlling a defect density in a silicon single crystal substrate will be described with reference to FIG. 1.

First, multiple test silicon single crystal substrates are prepared. The multiple test silicon single crystal substrates prepared here have different nitrogen concentrations from each other. Moreover, conditions other than the nitrogen concentration can be the same conditions as those of a silicon single crystal substrate which is an actual target of controlling a defect density (control-target silicon single crystal substrate).

Additionally, at this point, the defect to be controlled in relation to the defect density is preferably a composite containing carbon or carbon and oxygen. Silicon single crystal substrates have carbon and oxygen as impurities mixed during the crystal growth. When the defect density of such a silicon single crystal substrate is controlled by adjusting the nitrogen concentration of the silicon single crystal substrate based on a correlation between the nitrogen concentration and the concentration of a composite containing carbon or carbon and oxygen after heat treatment, this makes it possible to reduce a variation in defect density resulting from silicon single crystal substrates.

Further, the method for preparing the test silicon single crystal substrates is not particularly limited in the present invention. For example, the test silicon single crystal substrates can be prepared by slicing off silicon wafers from a silicon single crystal, performing a chemical etching treatment on the silicon wafers to eliminate the slicing damage, and then performing chemical-mechanical polishing.

Next, a measurement step is performed in which the multiple test silicon single crystal substrates are irradiated with a particle beam, then a heat treatment is performed, and the defect densities are measured (S11 in FIG. 1). Note that silicon single crystal substrates in parentheses in FIG. 1 indicate silicon single crystal substrates treated in the respective steps.

Here, before the particle beam irradiation, an oxide film or the like may be formed on the silicon single crystal substrates.

In the measurement step, defects are produced by the particle beam irradiation. It is desirable to match conditions for the particle beam irradiation with conditions employed in a particle beam irradiation step (S14 in FIG. 1) in a manufacturing process of the target semiconductor device. For example, as the particle beam, an electron beam can be radiated at a dosage of 1×10¹³ to 1×10¹⁵/cm² and an acceleration voltage of 0.5 to 2 MV.

Moreover, in the measurement step, a heat treatment (hereinafter, may be referred to as recovery heat treatment) is carried out after the particle beam irradiation. It is desirable to match conditions for the recovery heat treatment with conditions employed in a heat treatment step (S15 in FIG. 1) in the manufacturing process of the target semiconductor device. For example, it is possible to set the temperature at 300 to 400°C, the time of 10 to 60 minutes, and the atmosphere of nitrogen, oxygen, hydrogen, or the like.

Further, in the measurement step, the densities of defects produced in the multiple test silicon single crystal substrates are measured. As the method for measuring the defect densities, a cathode luminescence (CL) method or a photoluminescence (PL) method is preferably used.

The PL method is one method of evaluating light element composite. The PL method can detect composites of CiCs and CiOi, and can measure the relative densities of the composites based on emission intensities thereof. An emission line derived from CiCs is called a G-line, and an emission line derived from CiOi is called a C-line.

In the PL method, a semiconductor is irradiated with light having higher energy than bandgap (excitation light), and when electrons and holes thus generated recombine, light (luminescence) is emitted, and the intensity thereof is measured. This recombination is influenced by impurities and lattice defects having levels in a bandgap, and the light emission energy changes according to these levels. Thus, the impurities and lattice defects can be evaluated.

Another method of measuring luminescence is the CL method. In the CL method, a sample is irradiated with an electron beam, and when electrons and holes thus generated recombine, light is emitted, and the intensity thereof is measured. Like the PL method, the CL method is also known to detect composites of CiCs and CiOi.

As described above, the CL method and the PL method allow observation of G-line or C-line which are emission lines derived from a composite containing carbon or carbon and oxygen. Thus, the CL method or the PL method can be suitably employed as the method for measuring the concentration of a composite containing carbon or carbon and oxygen.

Next, a correlation acquisition step is performed (S12 in FIG. 1).

In the correlation acquisition step, the defect densities measured in the measurement step (S11 in FIG. 1) are associated with the nitrogen concentrations of the multiple test silicon single crystal substrates to acquire a correlation between the defect densities and the nitrogen concentrations.

Next, based on the correlation acquired as described above, a nitrogen concentration of a silicon single crystal substrate prepared in a preparation step is adjusted in such a manner that the defect density of the silicon single crystal substrate reaches a target value after the heat treatment step (S13 in FIG. 1).

The method for adjusting the nitrogen concentration of the control-target silicon single crystal substrate to be prepared is not particularly limited in the present invention. For example, it is possible to employ a method for adjusting conditions during silicon single crystal growth, or other similar methods. For example, in the FZ method, the nitrogen concentration in the silicon single crystal can be adjusted by adjusting the nitrogen concentration in an atmospheric gas during the single crystal growth. In the CZ method or the MCZ method in which magnetic field is applied, the nitrogen concentration in the silicon single crystal can be adjusted depending on the amount of silicon nitride added into a crucible. Alternatively, the nitrogen concentration in the silicon single crystal can be adjusted by heating the silicon single crystal substrate under an atmosphere containing nitrogen to inwardly diffuse nitrogen into the silicon single crystal substrate. Additionally, the nitrogen concentration in the silicon single crystal can be adjusted by implanting nitrogen ions from the surface of the silicon single crystal substrate.

In the present invention, the control-target silicon single crystal substrate to be prepared is preferably manufactured from a nitrogen-added silicon single crystal grown by an FZ method.

In the present invention, based on the correlation between the defect densities after the heat treatment step and nitrogen concentrations in FZ silicon single crystal substrates, the nitrogen concentration of the control-target silicon single crystal substrate is adjusted. Thereby, the defect density can be controlled, and this enables further reduction of a defect density variation resulting from silicon single crystal substrates. Accordingly, FZ silicon single crystal substrates suitable for power devices can be obtained.

Further, in the preparation step, the silicon single crystal substrate is preferably prepared to have the nitrogen concentration adjusted to vary from a target nitrogen concentration value at most by 10%. When the nitrogen concentration variation is within 10% (0% or more and 10% or less) as described above, the variation in defect density resulting from silicon single crystal substrates can be further reduced.

Next, the prepared control-target silicon single crystal substrate is subjected to a particle beam irradiation step (S14 in FIG. 1).

The conditions for the particle beam irradiation performed here are preferably the same as the conditions in the measurement step (S11 in FIG. 1). For example, an electron beam can be radiated at a dosage of 1×10¹³ to 1×10¹⁵/cm² and an acceleration voltage of 0.5 to 2 MV.

Next, the control-target silicon single crystal substrate irradiated with the particle beam is subjected to a heat treatment step (S15 in FIG. 1).

The conditions for the heat treatment performed here are preferably the same as the conditions in the measurement step (S11 in FIG. 1). For example, it is possible to set the temperature at 300 to 400°C, the time of 10 to 60 minutes, and the atmosphere of nitrogen, oxygen, hydrogen, or the like.

The inventive method for controlling a defect density as described above enables highly precise control of the defect density and reduction of a defect density variation resulting from silicon single crystal substrates.

In the present invention, a reason to use the method for controlling a defect density of a silicon single crystal substrate as described above to highly precisely control the defect density and reduce a defect density variation resulting from silicon single crystal substrates is based on the finding obtained by an experiment described below.

### [Experimental Example]

Multiple FZ silicon single crystal substrates having different nitrogen concentrations were prepared. The dopant type, dopant concentration, oxygen concentration, carbon concentration, nitrogen concentration, diameter, and crystal plane orientation of each of the multiple FZ silicon single crystal substrates are as follows.
Dopant type/concentration: phosphorous/6.3×10¹³ to 6.9×10¹³ atoms/cm³,
Oxygen concentration: <0.1 ppma (when the silicon starting material is polycrystalline silicon), 0.1 to 0.3 ppma (when the silicon starting material is single crystal silicon grown by the Czochralski method (CZ method)),
Carbon concentration: approximately 0.02 ppma,
Nitrogen concentration: 3.6×10¹⁴ to 2.2×10¹⁵ atoms/cm³, Diameter: 200 mm,
Crystal plane orientation: (100).

The oxygen concentration was measured by an infrared absorption method (using the conversion factor specified by JEIDA). The carbon concentration and the nitrogen concentration were measured by secondary ion mass spectrometry (SIMS).

The silicon single crystal substrates having an oxygen concentration of less than 0.1 ppma were manufactured from silicon single crystals grown by the FZ method using normal polycrystalline silicon ingots as starting materials. Moreover, the silicon single crystal substrates having an oxygen concentration of 0.1 to 0.3 ppma were manufactured from silicon single crystals grown by the FZ method using silicon single crystal ingots grown by the CZ method as starting materials. In this case, the use of the silicon single crystal ingots grown by the CZ method as starting materials results in an oxygen concentration variation in a range from 0.1 to 0.3 ppma due to difference in the concentrations of oxygen contained in the starting materials.

Next, the prepared silicon single crystal substrates were irradiated with an electron beam. In this event, the irradiation dosage of the electron beam was 1×10¹⁵/cm², and the acceleration voltage of the electron beam was 2 MV.

Next, the silicon single crystal substrates irradiated with the electron beam were subjected to a recovery heat treatment. The recovery heat treatment was performed at a temperature of 360°C under an atmosphere of nitrogen for a time of 45 minutes. Then, the emission spectra were measured by a cathode luminescence method.

FIG. 2 and FIG. 3 show examples of the emission spectra measured by the cathode luminescence method. FIG. 2 shows cases where the oxygen concentration was approximately 0.2 ppma, while the nitrogen concentration in FIG. 2(a) was 4.9×10¹⁴ atoms/cm³, and the nitrogen concentration in FIG. 2(b) was approximately 2.2×10¹⁵ atoms/cm³. In FIG. 2, G-lines (around 1305 nm) derived from CiCs and C-lines (around 1570 nm) derived from CiOi were observed, but the emission intensities of the C-lines in FIG. 2(a) and FIG. 2(b) are apparently different. This result indicates that the lower the nitrogen concentration, the lower the CiOi density.

FIG. 3 shows cases where the oxygen concentration was less than 0.1 ppma, while the nitrogen concentration in FIG. 3(a) was 3.6×10¹⁴ atoms/cm³, and the nitrogen concentration in FIG. 3(b) was approximately 1.7×10¹⁵ atoms/cm³. In FIG. 3, G-lines and C-lines were observed as in FIG. 2, but the emission intensities of the G-lines are apparently different between FIG. 3(a) and FIG. 3(b). This result indicates that the lower the nitrogen concentration, the higher the CiCs density. In FIG. 2 and FIG. 3, TO-lines derived from silicon (around 1130 nm) were also observed, but the emission intensities were so weak that the lines cannot be recognized as peaks in the scales of the figures.

Note that the emission wavelength (around 1305 nm) of the G-lines observed in this Experimental Example was shifted on the longer wavelength side in comparison with the emission wavelength (around 1270 nm) of common G-line, but it is known that the assignment range of these is the same.

Next, the G-line intensities and the C-line intensities were determined from the emission spectra.

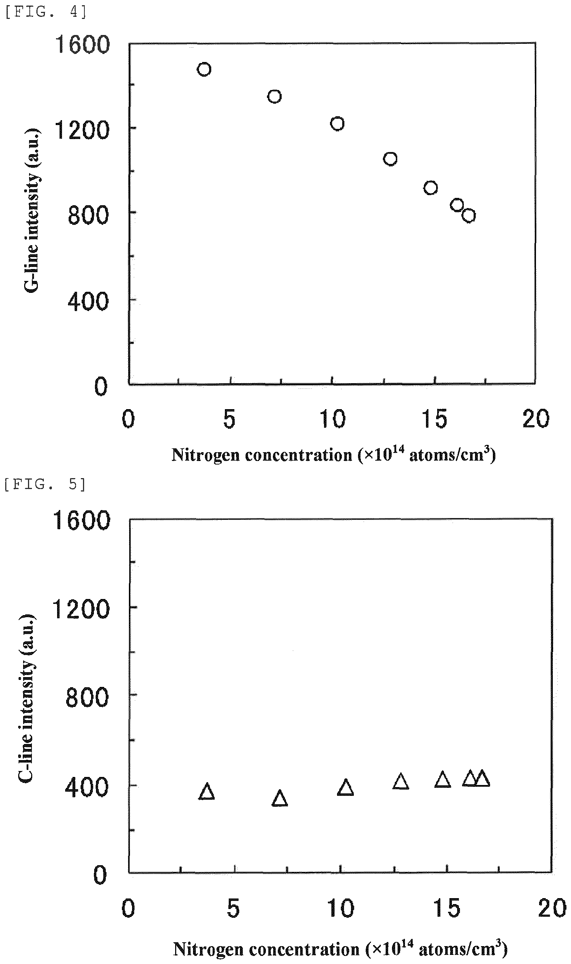

FIG. 4 shows a relation between the G-line intensities and the nitrogen concentrations in the silicon single crystal substrates having an oxygen concentration of less than 0.1 ppma. FIG. 5 shows a relation between the C-line intensities and the nitrogen concentrations. The results in FIG. 4 and FIG. 5 indicate that when the oxygen concentration is less than 0.1 ppma, the C-line intensity is low regardless of the nitrogen concentration, but the G-line intensity is decreased as the nitrogen concentration is increased. This suggests that even when the carbon concentration and the oxygen concentration remain approximately the same, increasing the nitrogen concentration decreases the CiCs density, provided that the oxygen concentration is less than 0.1 ppma. Moreover, it is suggested that when, for example, the CiCs density is to be increased with the CiOi density being kept low, the nitrogen concentration should be decreased, provided that the oxygen concentration is less than 0.1 ppma.

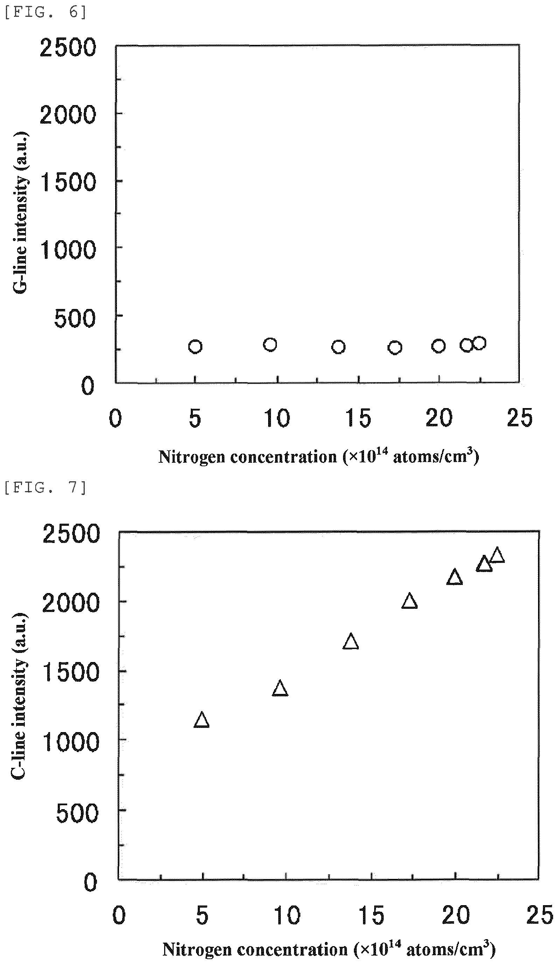

Regarding the silicon single crystal substrates having an oxygen concentration of 0.1 to 0.3 ppma, FIG. 6 shows a relation between the G-line intensities and the nitrogen concentrations, and FIG. 7 shows a relation between the C-line intensities and the nitrogen concentrations. The results in FIG. 6 and FIG. 7 indicate that when the oxygen concentration is 0.1 to 0.3 ppma, the G-line intensity is low regardless of the nitrogen concentration, but the C-line intensity is increased as the nitrogen concentration is increased. This suggests that even when the carbon concentration and the oxygen concentration remain approximately the same, increasing the nitrogen concentration increases the CiOi density, provided that the oxygen concentration is 0.1 to 0.3 ppma. Moreover, it is suggested that when, for example, the CiOi density is to be increased with the CiCs density being kept low, the nitrogen concentration should be increased provided that the oxygen concentration is 0.1 to 0.3 ppma.

Since it is known that the same emission lines are observed by a photoluminescence method and a cathode luminescence method, relations of G-line intensity and C-line intensity with respect to the nitrogen concentration can be obtained by a photoluminescence method also according to a similar process.

The oxygen concentrations of FZ silicon single crystal substrates differ depending on whether the silicon starting material used in manufacturing the crystal is polycrystalline silicon or single crystal silicon grown by the CZ method. Nevertheless, the variation in oxygen concentration can be reduced if the method for manufacturing the silicon starting material is the same.

Thus, it can be understood that adjusting the nitrogen concentration enables controlling the density of a composite containing carbon or carbon and oxygen in the FZ silicon single crystal substrates using either one of these starting materials.

As described above, the defect density is controlled by adjusting the nitrogen concentration of a silicon single crystal substrate whose defect density is to be controlled in such a manner that the defect density can reach a target value after the electron beam irradiation and the subsequent heat treatment are performed. This makes it possible to reduce a variation in defect density resulting from the silicon single crystal substrates themselves. Moreover, reducing a variation in nitrogen concentration enables reduction of the defect density variation.

A reason why the defect density depends on the nitrogen concentration when the electron beam irradiation and the subsequent heat treatment are performed as described above can be considered as follows.

When a silicon substrate is irradiated with a particle beam having high energy, a silicon atom at a lattice position is flicked out, and interstitial silicon (I) and a vacancy (V) which is an empty shell thereof are produced. The excessively produced I or V is unstable when it is alone, so that they recombine (V+I→0), clustering of I's or V's occurs, or they react with a light element impurity contained in the silicon substrate to form a composite. Additionally, the cluster of I's or V's or the composite of I or V with the light element impurity forms a deep level in a bandgap of silicon, functions as a recombination center or trap center of carriers, and influences the device characteristics.

It has been known that, as a defect concerning the vacancy V, V and substitutional phosphorous Ps react to form VP (V+Ps->VP) . Further, V and interstitial oxygen Oi react to form VO (V+Oi→VO), and V and VO react to form V₂O (V+VO→V₂O) in some cases. Furthermore, V's react with each other to form VV (V+V→VV). When nitrogen is present, V and N also react to form VN (V+N→VN). Since the reactions of V and P, O, or N compete against each other, if VN is apt to be formed when the nitrogen concentration is high, there is a possibility that other V-related composites are hardly formed.

On the other hand, it has been known that, as defects to which interstitial silicon I relates, I and substitutional boron Bs react to form interstitial boron Bi (I+Bs→Bi), and Bi and Oi react to form BiOi (Bi+Oi→BiOi). Furthermore, when carbon is present, I and substitutional carbon Cs react to form interstitial carbon Ci (I+Cs→Ci), and Ci and Oi or Ci and Cs react to form CiOi or CiCs (Ci+Oi→CiOi, Ci+Cs→CiCs). Moreover, I's react with each other to form an I cluster (I+I+...→In). When nitrogen is present at higher concentration, a reaction of V and N suppresses the recombination of V and I, and hence there is a possibility that an I-related composite is apt to be formed.

Since the reaction of I or V and a light element impurity is dependent on each absolute concentration and a concentration balance, this reaction is very complicated. Additionally, when the heat treatment is performed, annihilation or structural transformation of the composites occurs, resulting in further complexity.

In the above-described results of Experimental Example, when the oxygen concentration is 0.1 to 0.3 ppma, increasing the nitrogen concentration increases the CiOi density. This is conceivably because the reaction of V and N suppresses the recombination of V and I, so that I-related composite is apt to be formed. Meanwhile, when the oxygen concentration is less than 0.1 ppma, the CiOi density is low regardless of the nitrogen concentration. This is conceivably because the low Oi concentration suppresses CiOi formation regardless of the nitrogen concentration. Meanwhile, regarding CiCs, which is an I-related composite like CiOi, the reason why CiCs behaves differently from CiOi is not clear at present.

### EXAMPLE

Hereinafter, the present invention will be more specifically described with reference to Examples and Comparative Examples. However, the present invention is not limited thereto.

### [Example 1]

The defect density in a silicon single crystal substrate was controlled by the inventive method for controlling a defect density as shown in FIG. 1. In this case, an objective was to control the C-line intensity to approximately 2000 when measured by the cathode luminescence method as in Experimental Example.

First, in the measurement step, multiple test silicon single crystal substrates having different nitrogen concentrations were irradiated with an electron beam and then subjected to a heat treatment, and C-line intensities of the multiple test silicon single crystal substrates were measured. The test silicon single crystal substrates were manufactured from silicon single crystals grown by the FZ method, and had oxygen concentrations of 0.1 to 0.3 ppma.

The irradiation dosage of the electron beam in this case was 1×10¹⁵/cm², and the acceleration voltage of the electron beam was 2 MV. Moreover, in this case, the heat treatment temperature was 360°C, the time was 45 minutes, and the atmosphere was nitrogen.

Next, in the correlation acquisition step, a correlation between the C-line intensities and the nitrogen concentrations of the multiple test silicon single crystal substrates was acquired (FIG. 7).

Next, based on the correlation, the nitrogen concentration of a silicon single crystal substrate prepared in the preparation step was adjusted in such a manner that the C-line intensity of the silicon single crystal substrate reached the target value (approximately 2000) after the heat treatment step. The silicon single crystal substrate prepared in this event was manufactured from a silicon single crystal grown by the FZ method using a silicon single crystal ingot grown by the CZ method as a starting material. The oxygen concentration was approximately 0.2 ppma, and the nitrogen concentration was adjusted to 1.7×10¹⁵ atoms/cm³.

Then, the prepared silicon single crystal substrate was irradiated with an electron beam. The irradiation dosage of the electron beam was 1×10¹⁵/cm², and the acceleration voltage of the electron beam was 2 MV. Next, the silicon single crystal substrate irradiated with the electron beam was subjected to a recovery heat treatment. The recovery heat treatment temperature was 360°C, the atmosphere was nitrogen, and the time was 45 minutes.

As a result of measuring the C-line intensity by the cathode luminescence method after the recovery heat treatment, the C-line intensity of the silicon single crystal substrate was 2008.

As described above, it was confirmed that the target value of the defect density was achieved in Example 1 by adjusting the nitrogen concentration of the silicon single crystal substrate.

Moreover, five FZ silicon single crystal substrates were prepared. The nitrogen concentrations thereof had been adjusted in a range of 1.5×10¹⁵ to 1.9×10¹⁵ atoms/cm³ on the basis of the correlation obtained above. After the electron beam irradiation and recovery heat treatment were performed under the same conditions as described above, the C-line intensities were measured by the cathode luminescence method. Consequently, the C-line intensities were 1830, 2105, 1955, 2161, and 1876. This confirmed that a variation in defect density resulting from the silicon single crystal substrates themselves was suppressed quite small.

### [Comparative Example 1]

The defect density of a silicon single crystal substrate was controlled under the same conditions as those in Example 1 except that a correlation between defect densities and nitrogen concentrations was not obtained using test silicon single crystal substrates, and that the nitrogen concentration of the prepared silicon single crystal substrate was not adjusted based on the correlation.

In this case, the FZ silicon single crystal substrate having a nitrogen concentration of 1.0×10¹⁵ atoms/cm³ and an oxygen concentration of less than 0.1 ppma was irradiated with an electron beam and then subjected to the recovery heat treatment.

Subsequently, the C-line intensity after the recovery heat treatment was measured by the cathode luminescence method under the same conditions as those in Example 1. The result was 395.

As described above, it was confirmed that although the electron beam irradiation conditions and the recovery heat treatment conditions in Comparative Example 1 were the same as the conditions in Example 1, the C-line intensity of the silicon single crystal substrate became a value greatly deviating from the target value of 2000.

Moreover, five FZ silicon single crystal substrates having different nitrogen concentrations and oxygen concentrations were prepared randomly. After the electron beam irradiation and recovery heat treatment were performed under the same conditions as described above, the C-line intensities were measured by the cathode luminescence method. Consequently, the C-line intensities were 1157, 2276, 377, 435, and 1717. This confirmed that a variation in defect density resulting from the silicon single crystal substrates themselves was considerably large as compared with Example 1.

### [Example 2]

The defect density in a silicon single crystal substrate was controlled by the inventive method for controlling a defect density as shown in FIG. 1. In this case, an objective was to control the G-line intensity to approximately 1200 when measured by the cathode luminescence method as in Experimental Example.

First, in the measurement step, multiple test silicon single crystal substrates having different nitrogen concentrations were irradiated with an electron beam and then subjected to a heat treatment, and G-line intensities of the multiple test silicon single crystal substrates were measured. The test silicon single crystal substrates were manufactured from silicon single crystals grown by the FZ method using polycrystalline silicon ingots as starting materials. The oxygen concentrations were less than 0.1 ppma.

The irradiation dosage of the electron beam in this case was 1×10¹⁵/cm², and the acceleration voltage of the electron beam was 2 MV. Moreover, in this case, the heat treatment temperature was 360°C, the time was 45 minutes, and the atmosphere was nitrogen.

Next, in the correlation acquisition step, a correlation between the G-line intensities and the nitrogen concentrations of the multiple test silicon single crystal substrates was acquired (FIG. 4).

Next, based on the correlation, the nitrogen concentration of a silicon single crystal substrate prepared in the preparation step was adjusted in such a manner that the G-line intensity of the silicon single crystal substrate reached the target value (approximately 1200) after the heat treatment step. The silicon single crystal substrate prepared in this event was manufactured from a silicon single crystal grown by the FZ method using a polycrystalline silicon ingot as a starting material. The oxygen concentration was less than 0.1 ppma, and the nitrogen concentration was adjusted to 1.0×10¹⁵ atoms/cm³.

Then, the prepared silicon single crystal substrate was irradiated with an electron beam. The irradiation dosage of the electron beam was 1×10¹⁵/cm², and the acceleration voltage of the electron beam was 2 MV. Next, the silicon single crystal substrate irradiated with the electron beam was subjected to a recovery heat treatment. The recovery heat treatment temperature was 360°C, the atmosphere was nitrogen, and the time was 45 minutes.

As a result of measuring the G-line intensity by the cathode luminescence method after the recovery heat treatment, the G-line intensity of the silicon single crystal substrate was 1225.

As described above, it was confirmed that the target value of the defect density was achieved in Example 2 by adjusting the nitrogen concentration of the silicon single crystal substrate.

Moreover, five FZ silicon single crystal substrates were prepared. The nitrogen concentrations thereof had been adjusted in a range of 0.9×10¹⁵ to 1.1×10¹⁵ atoms/cm³ on the basis of the correlation obtained above. After the electron beam irradiation and recovery heat treatment were performed under the same conditions as described above, the G-line intensities were measured by the cathode luminescence method. Consequently, the G-line intensities were 1170, 1221, 1195, 1177, and 1265. This confirmed that a variation in defect density resulting from the silicon single crystal substrates themselves was suppressed quite small.

### [Comparative Example 2]

The defect density of a silicon single crystal substrate was controlled under the same conditions as those in Example 2 except that a correlation between defect densities and nitrogen concentrations was not obtained using test silicon single crystal substrates, and that the nitrogen concentration of the prepared silicon single crystal substrate was not adjusted based on the correlation.

In this case, the nitrogen concentration was 1.7×10¹⁵ atoms/cm³, and the oxygen concentration was less than 0.1 ppma. This FZ silicon single crystal substrate was irradiated with an electron beam and then subjected to the recovery heat treatment.

Subsequently, the G-line intensity after the recovery heat treatment was measured by the cathode luminescence method under the same conditions as those in Example 2. The result was 792.

As described above, it was confirmed that although the electron beam irradiation conditions and the recovery heat treatment conditions in Comparative Example 2 were the same as the conditions in Example 2, the G-line intensity of the silicon single crystal substrate became a value greatly deviating from the target value of 1200.

Moreover, five FZ silicon single crystal substrates having different nitrogen concentrations and oxygen concentrations were prepared randomly. After the electron beam irradiation and recovery heat treatment were performed under the same conditions as described above, the G-line intensities were measured by the cathode luminescence method. Consequently, the G-line intensities were 280, 286, 1480, 841, and 275. This confirmed that a variation in defect density resulting from the silicon single crystal substrates themselves was considerably large as compared with Example 1.

## Claims

1. A method for controlling a defect density in a silicon single crystal substrate by performing:
a preparation step of preparing a silicon single crystal substrate whose defect density is to be controlled;
a particle beam irradiation step of irradiating the prepared silicon single crystal substrate with a particle beam; and
a heat treatment step of performing a heat treatment on the silicon single crystal substrate after the particle beam irradiation step,
the method comprising:
a measurement step comprising irradiating a plurality of test silicon single crystal substrates having different nitrogen concentrations with the particle beam in advance before performing the preparation step, then carrying out a heat treatment, and measuring densities of defects produced in the plurality of test silicon single crystal substrates; and
a correlation acquisition step of acquiring a correlation between the measured defect densities and the nitrogen concentrations,
wherein a nitrogen concentration of the silicon single crystal substrate prepared in the preparation step is adjusted based on the acquired correlation in such a manner that the defect density in the silicon single crystal substrate reaches a target value after the heat treatment step.

2. The method for controlling a defect density in a silicon single crystal substrate according to claim 1, wherein the defect to be controlled in relation to the defect density is a composite containing carbon or carbon and oxygen.

3. The method for controlling a defect density in a silicon single crystal substrate according to claim 1 or 2, wherein the defect density is measured in the measurement step by a method of a cathode luminescence method or a photoluminescence method.

4. The method for controlling a defect density in a silicon single crystal substrate according to any one of claims 1 to 3, wherein the prepared silicon single crystal substrate is manufactured from a nitrogen-added silicon single crystal grown by a floating zone method.

5. The method for controlling a defect density in a silicon single crystal substrate according to any one of claims 1 to 4, wherein the nitrogen concentration of the silicon single crystal substrate prepared in the preparation step is adjusted to vary from a target nitrogen concentration value at most by 10%.

## Patentansprüche

1. Verfahren zur Kontrolle der Defektdichte in einem Silizium-Einkristallsubstrat durch Durchführung:
einen Präparationsschritt zur Herstellung eines Silizium-Einkristallsubstrats, dessen Defektdichte kontrolliert werden soll;
einen Teilchenstrahl-Bestrahlungsschritt, bei dem das hergestellte Silizium-Einkristallsubstrat mit einem Teilchenstrahl bestrahlt wird; und
einen Wärmebehandlungsschritt zur Durchführung einer Wärmebehandlung des Silizium-Einkristallsubstrats nach dem Teilchenstrahl-Bestrahlungsschritt,
wobei das Verfahren umfasst:
einen Messschritt, der das Bestrahlen einer Vielzahl von Test-Silizium-Einkristallsubstraten mit unterschiedlichen Stickstoffkonzentrationen mit dem Teilchenstrahl im Voraus vor der Durchführung des Präparationsschritts, das anschließende Durchführen einer Wärmebehandlung und das Messen der Dichten der in der Vielzahl der Test-Silizium-Einkristallsubstrate erzeugten Defekte umfasst; und
einen Korrelationserfassungsschritt, bei dem eine Korrelation zwischen den gemessenen Defektdichten und den Stickstoffkonzentrationen erfasst wird,
wobei eine Stickstoffkonzentration des in der Präparationsstufe hergestellten Silizium-Einkristallsubstrats auf der Grundlage der erfassten Korrelation so eingestellt wird, dass die Defektdichte in dem Silizium-Einkristallsubstrat nach der Wärmebehandlungsstufe einen Zielwert erreicht.

2. Verfahren zur Kontrolle einer Defektdichte in einem Silizium-Einkristallsubstrat nach Anspruch 1, wobei der in Bezug auf die Defektdichte zu kontrollierende Defekt ein Kohlenstoff oder Kohlenstoff und Sauerstoff enthaltender Verbundstoff ist.

3. Verfahren zur Kontrolle einer Defektdichte in einem Silizium-Einkristallsubstrat nach Anspruch 1 oder 2, wobei die Defektdichte in dem Messschritt durch ein Kathodenlumineszenzverfahren oder ein Photolumineszenzverfahren gemessen wird.

4. Verfahren zur Kontrolle der Defektdichte in einem Silizium-Einkristallsubstrat nach einem der Ansprüche 1 bis 3, wobei das hergestellte Silizium-Einkristallsubstrat aus einem mit Stickstoff versetzten Silizium-Einkristall hergestellt wird, der nach einem Schwebezonenverfahren gezüchtet wurde.

5. Verfahren zur Kontrolle der Defektdichte in einem Silizium-Einkristallsubstrat nach einem der Ansprüche 1 bis 4, wobei die Stickstoffkonzentration des im Präparationsschritt hergestellten Silizium-Einkristallsubstrats so eingestellt wird, dass sie von einem Zielwert der Stickstoffkonzentration höchstens um 10 % abweicht.

## Revendications

1. Procédé de contrôle d'une densité de défauts dans un substrat monocristallin de silicium par réalisation :
d'une étape de préparation consistant à préparer un substrat monocristallin de silicium dont la densité de défauts doit être contrôlée ;
d'une étape d'irradiation par un faisceau de particules consistant à irradier le substrat monocristallin de silicium préparé avec un faisceau de particules ; et
d'une étape de traitement thermique consistant à effectuer un traitement thermique sur le substrat monocristallin de silicium après l'étape d'irradiation par faisceau de particules, le procédé comprenant :
une étape de mesure comprenant l'irradiation d'une pluralité de substrats monocristallins de silicium d'essai ayant différentes concentrations d'azote avec le faisceau de particules à l'avance avant d'effectuer l'étape de préparation, puis la réalisation d'un traitement thermique, et la mesure des densités de défauts produits dans la pluralité de substrats monocristallins de silicium d'essai ; et
une étape d'acquisition de corrélation consistant à acquérir une corrélation entre les densités de défauts mesurées et les concentrations d'azote,
dans lequel une concentration en azote du substrat monocristallin de silicium préparé à l'étape de préparation est ajustée sur la base de la corrélation acquise de telle manière que la densité de défauts dans le substrat monocristallin de silicium atteigne une valeur cible après l'étape de traitement thermique.

2. Procédé de contrôle d'une densité de défauts dans un substrat monocristallin de silicium selon la revendication 1, dans lequel le défaut à contrôler par rapport à la densité de défauts est un composite contenant du carbone ou du carbone et de l'oxygène.

3. Procédé de contrôle d'une densité de défauts dans un substrat monocristallin de silicium selon la revendication 1 ou 2, dans lequel la densité de défauts est mesurée à l'étape de mesure par un procédé de luminescence cathodique ou un procédé de photoluminescence.

4. Procédé de contrôle d'une densité de défauts dans un substrat monocristallin de silicium selon l'une quelconque des revendications 1 à 3, dans lequel le substrat monocristallin de silicium préparé est fabriqué à partir d'un monocristal de silicium additionné d'azote obtenu par un procédé de zone flottante.

5. Procédé de contrôle d'une densité de défauts dans un substrat monocristallin de silicium selon l'une quelconque des revendications 1 à 4, dans lequel la concentration en azote du substrat monocristallin de silicium préparé à l'étape de préparation est ajustée pour varier d'une valeur de concentration d'azote cible au plus de 10 %.
